# EUROPÄISCHE PATENTSCHRIFT

(11) **EP 3 350 609 B1**
(45) Veröffentlichungstag und Bekanntmachung des Hinweises auf die Patenterteilung: **29.05.2024**
(21) Anmeldenummer: 16763500.2
(22) Anmeldetag: 06.09.2016
(51) Int. Cl.: G01R 31/36, H01M 10/48, H01M 10/42

(54) **VERFAHREN ZUR DETEKTION EINES INTERNEN KURZSCHLUSSES IN EINER BATTERIE**
METHOD FOR DETECTING AN INTERNAL SHORT CIRCUIT IN A BATTERY
PROCÉDÉ DE DÉTECTION D'UN COURT-CIRCUIT INTERNE DANS UNE BATTERIE

(30) Priorität: 18.09.2015 DE 102015217927
(43) Veröffentlichungstag der Anmeldung: 25.07.2018
(73) Patentinhaber: Robert Bosch GmbH, 70442 Stuttgart (DE); GS Yuasa International Ltd., Kisshoin, Minami-ku, Kyoto-shi, Kyoto 601-8520 (JP)
(72) Erfinder: BECKER, Jens, 67071 Ludwigshafen Am Rhein (DE); ZAFIRIDIS, Triantafyllos, 74072 Heilbronn (DE); SOHNS, Joachim, 71636 Ludwigsburg (DE); COIS, Olivier, 71394 Kernen (DE)
(74) Vertreter: Isarpatent
(86) Internationale Anmeldenummer: PCT/EP2016/070953
(87) Internationale Veröffentlichungsnummer: WO 2017/045973

(56) Entgegenhaltungen:
- EP-A1- 2 175 515
- EP-A2- 2 343 558
- CN-Y- 201 421 017
- DE-A1-102011 077 311
- JP-A- 2002 340 959
- JP-A- 2014 045 579
- US-A- 4 547 734
- US-A1- 2007 261 475
- US-A1- 2009 099 799
- US-A1- 2009 130 542
- US-A1- 2010 194 398

## Beschreibung

Die vorliegende Erfindung betrifft ein Verfahren zur Detektion eines kritischen Zustands bei zumindest einer Batteriezelle einer Batterie, wobei eine Überwachungsvorrichtung vorgesehen ist, und die Überwachungsvorrichtung eine gemessene Spannung an der Batteriezelle erfasst und eine modellierte Spannung aus einem Modell bestimmt. Weiter betrifft die vorliegende Erfindung eine Überwachungsvorrichtung zur Detektion eines kritischen Zustands bei zumindest einer Batteriezelle einer Batterie.

### Stand der Technik

Es ist aus dem Stand der Technik bekannt, verschiedene physikalische Größen bei Batteriezellen zu messen und auszuwerten, um kritische Zustände der Batterie, wie zum Beispiel interne Kurzschlüsse der Batteriezellen, zu detektieren. Aufgrund der zunehmend steigenden Energiedichte von Batterien, insbesondere von Lithium-Ionen Batterien, kommt der Detektion der kritischen Zustände eine hohe Bedeutung zu.

In der DE 10 2013 204 524 A1 ist offenbart, dass eine Sensorvorrichtung zur Erfassung von mehreren die Batteriezelle betreffenden physikalischen Größen genutzt wird. Dabei kann anhand einer Auswertung von durch die Sensorvorrichtung bereitgestellten aktuellen Messwerten ein Batteriezellenzustand erkannt werden.

Aus der DE 10 2011 100 392 A1 ist ein Verfahren zur Überwachung eines Sicherheitsstromkreises bekannt. Hierbei wird ein Vergleichsmittel genutzt, um eine Stromkreisspannung mit einer Referenzspannung zu vergleichen.

In der DE 10 2011 080 605 A1 ist offenbart, dass ein Innenwiderstand mindestens einer Batteriezelle der Batterie wiederholt ermittelt wird und der zeitliche Verlauf beobachtet wird.

Die Druckschrift DE 10 2011 077311 A1 offenbart ein Verfahren zur Erkennung einer Auslösung einer Sicherheitseinrichtung, wobei die Sicherheitseinrichtung einer Batteriezelle zugeordnet ist und ausgelöst wird, wenn eine sicherheitskritische Situation in der Batteriezelle vorliegt.

Die Druckschrift EP 2 343 558 A2 offenbart ein Batteriesystem mit einem Batteriesatz, einer Erfassungseinheit, einer Speichereinheit und einer Bestimmungseinheit.

Die Druckschrift EP 2 175 515 A1 offenbart eine interne Kurzschlusserfassungsvorrichtung zum Erfassen eines internen Kurzschlusses einer Batterie, die einer Konstantstromladung ausgesetzt ist, unter Verwendung einer konstanten Stromstärke.

Die Druckschrift JP 2002 340959 A offenbart eine Kondensatorspeichereinrichtung, in der eine Vielzahl von Einheits-Kondensatorzellen in Reihe und parallel geschaltet sind.

### Offenbarung der Erfindung

Gegenstand der Erfindung ist ein Verfahren sowie eine Überwachungsvorrichtung mit den Merkmalen der jeweiligen unabhängigen Ansprüche. Durch die Erfindung kann auf eine aufwendige Messtechnik (mit zahlreichen und teuren Sensoren) verzichtet werden und trotzdem frühzeitig und schnell ein technischer Defekt, insbesondere in Form eines Kurzschlusses, einer einzelnen Batteriezelle zuverlässig bestimmt werden. Weitere Merkmale und Details der Erfindung ergeben sich aus den jeweiligen Unteransprüchen, der Beschreibung und den Zeichnungen. Dabei gelten Merkmale und Details, die im Zusammenhang mit dem erfindungsgemäßen Verfahren beschrieben sind, selbstverständlich auch im Zusammenhang mit der erfindungsgemäßen Überwachungsvorrichtung, und jeweils umgekehrt, sodass bezüglich der Offenbarung zu den einzelnen Erfindungsaspekten stets wechselseitig Bezug genommen wird bzw. werden kann.

Das erfindungsgemäße Verfahren dient insbesondere zur Detektion eines kritischen Zustands, insbesondere eines internen Kurzschlusses, bei zumindest einer Batteriezelle einer Batterie. Hierbei ist vorgesehen, dass eine Überwachungsvorrichtung eine gemessene Spannung an der Batteriezelle (insbesondere für jede einzelne Batteriezelle) erfasst und (insbesondere zeitgleich) eine modellierte Spannung (insbesondere für die jeweilige Batteriezelle) aus einem (vorgegebenen) Modell bestimmt, vorzugsweise berechnet, wobei die nachfolgenden Schritte, bevorzugt (also optional) zeitlich nacheinander, durchgeführt werden:
a) Vergleichen einer gemessenen (insbesondere zeitlichen) Veränderung der gemessenen Spannung der Batteriezelle mit einer modellierten (insbesondere zeitlichen) Veränderung der modellierten Spannung, wobei in Abhängigkeit von diesem Vergleich ein Vergleichssignal der Batteriezelle bestimmt wird,
b) Auswerten des Vergleichssignals der Batteriezelle zur Detektion des kritischen Zustands, insbesondere des Kurzschlusses,
c) Vergleichen eines durchschnittlichen Vergleichssignals, insbesondere gebildet aus weiteren Vergleichssignalen von wenigstens zwei oder mehr oder sämtlichen weiteren Batteriezellen der Batterie, mit dem Vergleichssignal der, insbesondere einzelnen, Batteriezelle, zur Bestimmung eines ersten Auswertungssignals.

Hierdurch kann gewährleistet werden, dass kritische Zustände, insbesondere einzelne Zelldefekte wie interne Kurzschlüsse, sicher und zuverlässig erkannt werden. Als Reaktion auf die Detektion des kritischen Zustands können bspw. entsprechende Sicherheitsmechanismen ausgeführt werden. Die Heranziehung einer modellbasierten (d. h. modellierten) Spannung als Referenz für den Vergleich mit der gemessenen Spannung ermöglicht dabei eine besonders zuverlässige und schnelle Detektion der kritischen Zustände.

Insbesondere wird jeweils eine gemessene Spannung, d. h. insbesondere ein Spannungsverlauf, für jede der einzelnen Batteriezellen erfasst und jeweils eine modellierte Spannung, d. h. insbesondere ein Spannungsverlauf, aus dem Modell für die jeweilige Batteriezelle bestimmt, und für jede der Batteriezellen jeweils Schritt a) und/oder b) durchgeführt und/oder jeweils ein Vergleichssignal für jede der Batteriezellen gebildet. Somit kann jede Batteriezelle einzeln überwacht werden und der Spannungsverlauf und/oder das Vergleichssignal jeder einzelnen Batteriezelle individuell ausgewertet werden.

Die Batteriezelle ist bevorzugt eine Lithium-Ionen Zelle, wobei besonders bevorzugt die Batterie als ein Akkumulator und/oder ein Batteriesystem und/oder eine Lithium-Ionen Batterie ausgebildet ist. Die Batterie umfasst vorzugsweise mehrere Batteriezellen, insbesondere mindestens 2 oder mindestens 10 oder mindestens 50 oder mindestens 100 Batteriezellen, wobei bspw. jede einzelne gemäß dem erfindungsgemäßen Verfahren (zumindest temporär) überwacht wird, d. h. die Schritte a) und/oder b) können bei jeder Batteriezelle durchgeführt werden. Insbesondere Lithium-Ionen Zellen haben den Vorteil, eine besonders hohe Energiedichte aufzuweisen. Es kommt daher besonders darauf an, eine schnelle und zuverlässige Detektion von kritischen Zuständen zu ermöglichen.

Gemäß einer vorteilhaften Weiterbildung der Erfindung kann vorgesehen sein, dass gemäß Schritt a) eine erste Filterung, insbesondere eine erste Hochpass-Filterung, an der gemessenen Spannung zur Bestimmung der gemessenen Veränderung durchgeführt wird, und vorzugsweise eine zweite Filterung, insbesondere eine zweite Hochpass- Filterung, an der modellierten Spannung zur Bestimmung der modellierten Veränderung durchgeführt wird, und für den Vergleich gemäß Schritt a) bevorzugt die Differenz zwischen der gemessenen Veränderung und der modellierten Veränderung (insbesondere für die jeweilige Batteriezelle und/oder für jede der Batteriezellen) gebildet wird. Hierdurch kann zuverlässig die Veränderung, d. h. insbesondere ein Spannungsabfall und/oder - anstieg, bestimmt werden.

Die Überwachung, d. h. insbesondere die Erfassung der gemessenen Spannung an jeder Batteriezelle und/oder die (simultane) Bestimmung der modellierten Spannung durch die Überwachungsvorrichtung und/oder der Vergleich gemäß Schritt a) und/oder die Auswertung gemäß Schritt b) des erfindungsgemäßen Verfahrens erfolgt dabei vorzugsweise zyklisch während des Betriebs der Batterie. Dabei definiert insbesondere ein Messzyklus einen Messzeitpunkt, an welchem (gleichzeitig) die modellierte Spannung, insbesondere als Spannungsverlauf, und/oder die gemessene Spannung, insbesondere als Spannungsverlauf, und/oder die gemessene und/oder modellierte Veränderung ermittelt werden. Mit anderen Worten wird wiederholt in bestimmten (zeitlichen) Abständen ein Messzyklus (z. B. alle 0,1 bis 10 Sekunden, insbesondere alle 2 bis 4 Sekunden) durchgeführt, wobei vorzugsweise in jedem Zyklus bei jeder überwachten Batteriezelle jeweils die Schritte des erfindungsgemäßen Verfahrens durchgeführt werden. Der Messzyklus wird bspw. u. a. dadurch bestimmt, in welchem Zeitraum eine Auswertung der gemessenen und/oder modellierten Spannung zur Bestimmung der gemessenen und/oder modellierten Veränderung z. B. durch die Filterung erfolgt. Dieser Zeitraum lässt sich bspw. bei einem Hochpassfilter konfigurieren. Auch kann es möglich sein, dass die Veränderung durch eine Ableitung und/oder Differenzbildung der gemessenen / modellierten Spannung in dem Zeitraum (Zyklus) bestimmt wird. Diese Veränderung ist z. B. ein Spannungsabfall, welcher bspw. dann auftritt, wenn sich die Last der Batterie ändert oder dergleichen. Ein kritischer Zustand und/oder Kurzschluss wird vorzugsweise dann detektiert, wenn der Spannungsabfall bspw. größer als 20 mV bis 25 mV ist. Zur Detektion wird dann bevorzugt die Auswertung gemäß Schritt b) durchgeführt und/oder ein entsprechender Schwellenwert definiert. Damit kann zuverlässig ein kritischer Zustand / Kurzschluss detektiert werden.

Ein weiterer Vorteil kann im Rahmen der Erfindung erzielt werden, wenn zur Auswertung des Vergleichssignals gemäß Schritt b) der Schritt c) durchgeführt wird.

Der Schritt c), d. h. die Bestimmung des ersten Auswertungssignals, wird bevorzugt für jede der Batteriezellen durchgeführt. So ist bspw. denkbar, dass die Überwachung, insbesondere die Bestimmung des Vergleichssignals und/oder die Auswertung des Vergleichssignals, für mindestens zwei oder sämtliche Batteriezellen der Batterie durchgeführt werden. Vorzugsweise wird das jeweilige Vergleichssignal von jeder dieser Batteriezellen zur Bestimmung des durchschnittlichen Vergleichssignals herangezogen. Dazu werden bspw. die sämtlichen jeweiligen Vergleichssignale aufaddiert oder sämtliche Vergleichssignale gemittelt, wobei das Ergebnis das durchschnittliche Vergleichssignal ergibt. Es wird bspw. ein durchschnittliches Vergleichssignal für jeden Messzyklus und/oder jeden Messzeitpunkt ermittelt. Bevorzugt wird der Vergleich des durchschnittlichen Vergleichssignals mit dem Vergleichssignal der jeweiligen Batteriezellen ebenso für jede Batteriezelle durchgeführt, um für jede Batteriezelle ein jeweiliges erstes Auswertungssignal zu bestimmen. Das erste Auswertungssignal trägt dabei z. B. das Ergebnis des Vergleichs, z. B. einer Differenzbildung. So wird besonders bevorzugt für den Vergleich das jeweilige Vergleichssignal der Batteriezelle von dem durchschnittlichen Vergleichssignal subtrahiert, um das erste Auswertungssignal zu bestimmen. Insbesondere wird für jede Batteriezelle eine eigene modellierte Spannung (d. h. auch Spannungs- verlauf) ermittelt, und damit eine für die jeweilige Batteriezelle spezifische modellierte Veränderung und ein spezifisches Vergleichssignal gemäß Schritt a) bestimmt. Allerdings ist das Modell, welches zur (insbesondere digitalen) Bestimmung der modellierten Spannung und/oder Veränderung genutzt wird, vorzugsweise für jede Batteriezelle gleich (lediglich die Parametrisierung des Modells durch bspw. Zellstrom und Innenwiederstand und dergleichen
unterscheidet sich und erfolgt für die jeweilige Batteriezelle spezifisch / individuell). Daher ist insbesondere auch die systematische Abweichung des Modells, d. h. die Abweichung des prädizierten Spannungsverlaufs zum tatsächlichen Spannungsverlauf (d. h. zur gemessenen Spannung), für alle Batteriezellen im Wesentlichen gleich. Der Vergleich gemäß Schritt c), d. h. zum Beispiel eine Differenzbildung, kann daher einen systematischen Fehler von bspw. dem Modell und damit das systematische Rauschen verringern.

Es ist ferner denkbar, dass zur Auswertung des Vergleichssignals gemäß Schritt b) der nachfolgende Schritt durchgeführt wird, insbesondere (zeitlich) nach Schritt c):
d) Kompensieren von systematischen Fehlereinflüssen, insbesondere bei dem ersten Auswertungssignal, zur Bestimmung eines zweiten Auswertungssignals.

Dabei sind die Fehlereinflüsse, welche ein Rauschen bedingen, insbesondere abhängig von Umgebungsbedingungen, Alterung und dergleichen und damit unterschiedlich für unterschiedliche Batteriezellen. Die Kompensation erfolgt dabei insbesondere durch die Berücksichtigung vorbestimmter und vom System abhängiger Parameter, welche bspw. durch Simulation und/oder Messung ermittelt wurden. Weiter können auch mathematische Methoden zur Kompensation eingesetzt werden, wie z. B. eine (quadratische) Mittelwertbildung, Prädiktion oder dergleichen. Das erfindungsgemäße Verfahren ermöglicht es hierdurch, insbesondere durch die Verringerung des Signalrauschens, die Robustheit der Detektion zu erhöhen.

Ferner kann im Rahmen der Erfindung vorgesehen sein, dass zur Auswertung des Vergleichssignals gemäß Schritt b) der nachfolgende Schritt durchgeführt wird, insbesondere (zeitlich) nach Schritt d):
e) Vergleichen des zweiten Auswertungssignals der (insbesondere jeweiligen) Batteriezelle mit einem weiteren zweiten Auswertungssignal von einer weiteren Batteriezelle, insbesondere durch Berechnung der Differenz, um ein Detektionssignal zu bestimmen, insbesondere nur dann, wenn das Detektionssignal größer null ist und/oder das zweite Auswertungssignal der (jeweiligen) Batteriezelle einem maximalen Auswertungssignal (unter Berücksichtigung von z. B. sämtlicher überwachten Batteriezellen) der Batterie entspricht, wobei insbesondere das weitere zweite Auswertungssignal der weiteren Batteriezelle einem zweithöchsten Auswertungssignal entspricht.

Das maximale Auswertungssignal ist dabei bevorzugt nur das zweite Auswertungssignal, d. h. insbesondere der Wert, von der Batteriezelle, welche zu einem gegebenen Messzeitpunkt und/oder Messzyklus das höchste zweite Auswertungssignal mit dem maximalen Wert im Vergleich zu den weiteren zweiten Auswertungssignalen der anderen Batteriezellen aufweist. Das zweithöchste Auswertungssignal ist dabei entsprechend bevorzugt nur das zweite Auswertungssignal, d. h. insbesondere der Wert, von der Batteriezelle, welche zu einem gegebenen Messzeitpunkt und/oder Messzyklus das zweithöchste zweite Auswertungssignal mit dem zweithöchsten Wert im Vergleich zu den weiteren zweiten Auswertungssignalen der anderen Batteriezellen aufweist. Die Batteriezelle mit dem zweithöchsten Auswertungssignal unterscheidet sich damit zwangsläufig von der Batteriezelle mit dem maximalen Auswertungssignal. Vorzugsweise findet gemäß Schritt e) also eine globale Auswertung aller überwachten Batteriezellen statt, während die Schritte a) bis d) bevorzugt für sämtliche überwachten Batteriezellen einzeln und/oder in gleicher Art und Weise und/oder unabhängig voneinander erfolgen. Dabei wird davon ausgegangen, dass die Batteriezelle mit dem höchsten zweiten Auswertungssignal (dem maximalen Auswertungssignal) möglicherweise einen kritischen Zustand aufweist, wobei die weiteren Batteriezellen und damit auch die Batteriezelle mit dem zweithöchsten (zweiten) Auswertungssignal fehlerfrei sind und lediglich Rauscheinflüssen unterworfen sind. Der Vergleich des zweiten (höchsten) Auswertungssignals mit dem weiteren zweiten (zweithöchsten) Auswertungssignal erfolgt zum Beispiel durch Differenzbildung, so dass bspw. der Rauscheinfluss (Störeinfluss) vom höchsten Auswertungssignal abgezogen werden kann. Hierdurch wird die Zuverlässigkeit für die Detektion und somit die Zuverlässigkeit des Verfahrens weiter erhöht.

Ferner kann es im Rahmen der Erfindung vorgesehen sein, dass zur Auswertung des Vergleichssignals gemäß Schritt b) die nachfolgenden Schritte durchgeführt werden, insbesondere (zeitlich) nach Schritt e):
f) Bestimmen eines Integrationssignals, insbesondere durch Integrieren und/oder Aufsummieren des Detektionssignals,
g) Verwerfen des Integrationssignals, d. h. z. B. zurücksetzen oder auf null setzen, wenn das zweite Auswertungssignal der Batteriezelle sich von einem maximalen Auswertungssignal der Batterie unterscheidet.

Ein kritischer Zustand, insbesondere ein Kurzschluss, kann bspw. dann für eine bestimmte Batteriezelle erkannt werden, wenn die Batteriezelle auch nach einiger Zeit (nach einigen Messzyklen) noch das maximale Auswertungssignal aufweist. Sollte allerdings in dieser Zeit eine andere Batteriezelle das maximale Auswertungssignal aufweisen, so ist davon auszugehen, dass das maximale Auswertungssignal nur durch Stör- bzw. Rauscheinflüsse bei sonst fehlerfreier Funktion entstanden ist. Daher kann eine Integration insbesondere über eine bestimmte Integrationsdauer durchgeführt, um Störeinflüsse oder Fehlerkennungen weiter reduzieren zu können.

Es kann ferner möglich sein, dass der kritische Zustand, insbesondere ein interner Kurzschluss der Batteriezelle, gemäß Schritt b) nur dann positiv detektiert wird, wenn das Integrationssignal einen vordefinierten Schwellenwert überschreitet. Übersteigt das aus der Integration oder Aufsummation gebildete Integrationssignal den Schwellenwert, und/oder übersteigt (zudem) die Integrationsdauer einen zeitlichen Schwellenwert, so wird vorzugsweise ein kritischer Zustand detektiert. Allerding wird insbesondere die Integration zuvor beendet (verworfen) und/oder der Wert des Integrationssignals verringert und/oder die Integrationsdauer beendet, wenn die Batteriezelle mit dem maximalen Auswertungssignal wechselt. So endet dann die Integrationsdauer und/oder die Integration beginnt erneut für die Batteriezelle mit dem maximalen Auswertungssignal. Damit wird eine Fehlerkennung zuverlässig verhindert.

Vorteilhafterweise kann bei der Erfindung vorgesehen sein, dass für zumindest 50 % oder zumindest 80 % oder zumindest 90 % oder für sämtliche der Batteriezellen der Batterie jeweils die Schritte a) und b), und insbesondere wenigstens einer der Schritte c) bis g), insbesondere gleichzeitig bzw. simultan bei den Batteriezellen bzw. innerhalb eines Messzyklus, durchgeführt werden, wobei insbesondere das Integrationssignal und/oder das Detektionssignal stets nur für die Batteriezelle mit dem maximalen Auswertungssignal der Batterie ermittelt wird. Somit ist die Detektion besonders effizient und zuverlässig durchführbar.

Ebenfalls Gegenstand der Erfindung ist eine Überwachungsvorrichtung zur Detektion eines kritischen Zustands, insbesondere eines internen Kurzschlusses, bei zumindest einer Batteriezelle einer Batterie. Die Überwachungsvorrichtung weist vorzugsweise auf:
- zumindest eine Messeinheit zur Erfassung insbesondere jeweils einer gemessenen Spannung für insbesondere jede Batteriezelle,
- zumindest eine Auswerteeinheit zur Bestimmung (und insbesondere digitalen Berechnung) von insbesondere jeweils einer modellierten Spannung aus einem Modell für insbesondere jede Batteriezelle.

Die Messeinheit misst z. B. für jede Batteriezelle pro Messzyklus mindestens einen Wert für die gemessene Spannung und die Auswerteeinheit bestimmt insbesondere für jede Batteriezelle pro Messzyklus mindestens einen Wert für eine modellierte Spannung.

Damit bringt die erfindungsgemäße Überwachungsvorrichtung die gleichen Vorteile mit sich, wie sie ausführlich mit Bezug auf ein erfindungsgemäßes Verfahren beschrieben worden sind. Weiter ist die Überwachungsvorrichtung gemäß einem erfindungsgemäßen Verfahren betreibbar. Weiter ist es denkbar, dass die Auswerteeinheit derart ausgeführt ist, dass die verschiedenen Werte für die gemessene und/oder modellierte Spannung für unterschiedliche Batteriezellen in jedem Messzyklus miteinander durch die Auswerteeinheit (insbesondere gemäß Schritt a) des erfindungsgemäßen Verfahrens) vergleichbar und/oder (insbesondere gemäß Schritt b) des erfindungsgemäßen Verfahrens) auswertbar sind.

Auch ist die Erfindung auf zumindest eine Batterie, die einzelnen Batteriezellen aufweist, mit der erfindungsgemäßen Überwachungsvorrichtung gerichtet.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen:
- Fig. 1: eine schematische Darstellung zur Visualisierung eines erfindungsgemäßen Verfahrens sowie einer erfindungsgemäßen Überwachungsvorrichtung,
- Fign. 2 - 4: weitere schematische Darstellungen zur Visualisierung eines erfindungsgemäßen Verfahrens,
- Fig. 5: eine schematische Darstellung eines zweiten Auswertungssignals, eines Detektionssignals und eines Integrationssignals.

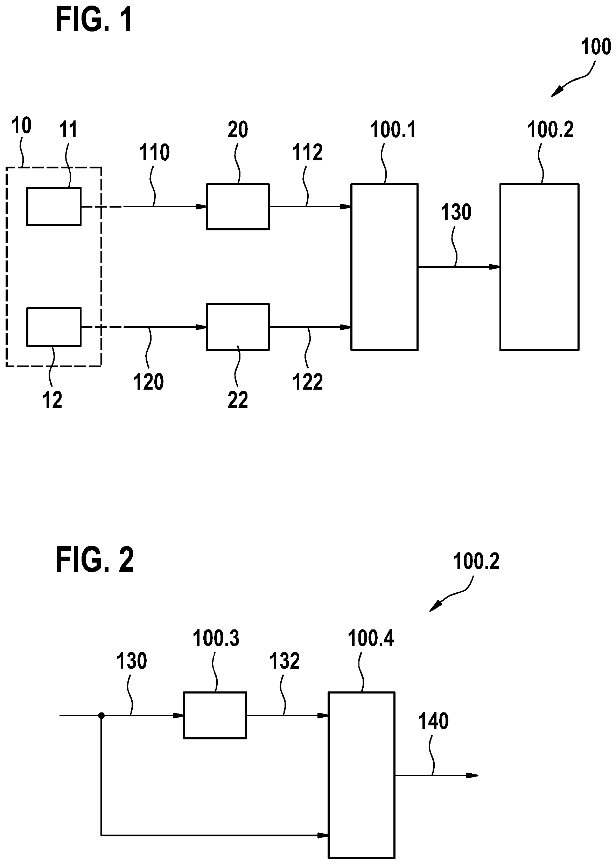

In Figur 1 wird schematisch ein erfindungsgemäßes Verfahren 100 visualisiert. Weiter sind schematisch Teile einer erfindungsgemäßen Überwachungsvorrichtung 10 dargestellt. Die Überwachungsvorrichtung 10 weist dabei zumindest eine Messeinheit 11 und zumindest eine Auswerteeinheit 12 auf. Die Messeinheit 11 misst an einer oder mehrerer Batteriezellen der Batterie eine Zellspannung, wobei für jede der Batteriezellen jeweils eine gemessene Spannung 110 erfasst wird. Außerdem wird für jede Batteriezelle durch eine oder mehrere Auswerteeinheiten 12 jeweils eine modellierte Spannung 120 aus einem Modell bestimmt. Anschließend wird eine gemessene Veränderung 112 der gemessenen Spannung 110 und eine modellierte Veränderung 122 der modellierten Spannung 120 z. B. durch die Auswerteeinheit 12 ermittelt. Hierzu kann eine erste Filterung 20, z. B. eine erste Hochpass-Filterung 20, an der gemessenen Spannung 110 und eine zweite Filterung 22, insbesondere eine zweite Hochpass-Filterung 22, an der modellierten Spannung 120 durchgeführt werden. Gemäß einem ersten Verfahrensschritt 100.1 wird dann die gemessene Veränderung 112 mit der modellierten Veränderung 122 verglichen, wobei in Abhängigkeit von diesem Vergleich ein Vergleichssignal 130 der Batteriezelle bzw. für jede Batteriezelle bestimmt wird. Es erfolgt anschließend insbesondere durch die Auswerteeinheit 12 ein Auswerten des Vergleichssignals 130 für jede Batteriezelle zur Detektion des kritischen Zustandes gemäß einem zweiten Verfahrensschritt 100.2.

Die Auswertung des Vergleichssignals 130 gemäß dem zweiten Verfahrensschritt 100.2 wird in den Figuren 2 bis 4 näher erläutert. Gemäß einem dritten Verfahrensschritt 100.3 wird ein durchschnittliches Vergleichssignal 132 aus sämtlichen Vergleichssignalen 130 der überwachten Batteriezellen ermittelt. Dieses durchschnittliche Vergleichssignal 132 wird dann gemäß dem vierten Verfahrensschritt 100.4 mit dem jeweiligen Vergleichssignal 130 der einzelnen Batteriezelle verglichen. Das daraus resultierende erste Auswertungssignal 140 wird weiter gemäß einem fünften Verfahrensschritt 100.5 verändert, um systematische Fehler zu kompensieren. Dieses kompensierte erste Auswertungssignal 140 wird dann z. B. gemäß einem sechsten Verfahrensschritt 100.6 von dem ersten Auswertungssignal 140 abgezogen. Hieraus resultiert ein zweites Auswertungssignal 150.

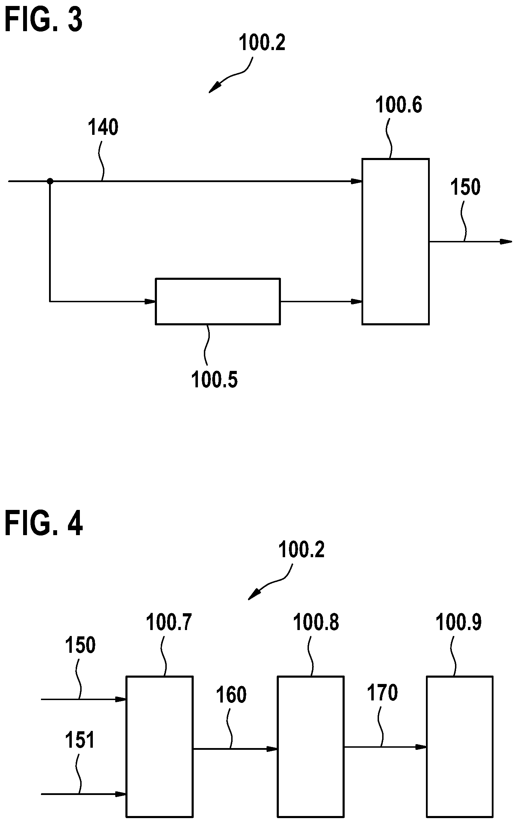

In Figur 4 ist weiter gezeigt, dass als nachfolgende Verfahrensschritte ein siebter Verfahrensschritt 100.7 zur Anwendung kommt. Dabei wird aus dem zweiten Auswertungssignal 150 und einem weiteren zweiten Auswertungssignal 151 die Differenz gebildet. Bei dem weiteren zweiten Auswertungssignal 151 handelt es sich insbesondere um das zweite Auswertungssignal einer Batteriezelle mit dem zweithöchsten Wert. Ist das aus der Differenzbildung resultierende Detektionssignal 160 größer als null (d. h. das zweite Auswertungssignal 150 der Batteriezelle entspricht dem max. Auswertungssignal und ist damit größer als das weitere zweite Auswertungssignal 151), so wird gemäß einem achten Verfahrensschritt 100.8 eine Integration des Detektionssignals 160 durchgeführt. In einem neunten Verfahrensschritt 100.9 wird das integrierte Signal (Integrationssignal 170) mit einem Schwellenwert S verglichen, um einen kritischen Zustand zu detektieren.

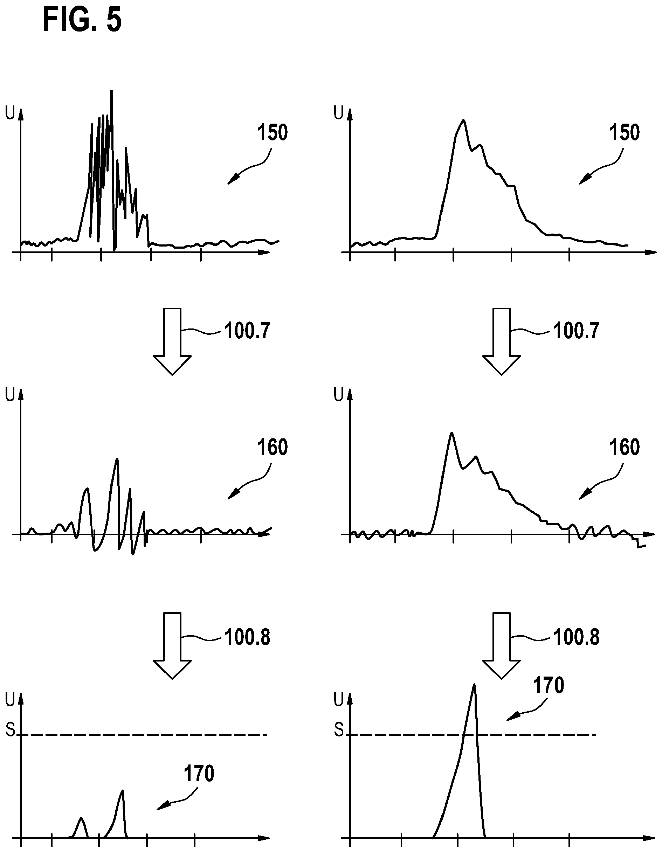

In Figur 5 sind beispielhaft ein zweites Auswertungssignal 150, ein Detektionssignal 160 und ein Integrationssignal 170 sowohl für einen kritischen Zustand (rechts) als auch für einen unkritischen Zustand (links) dargestellt. Auf der linken Seite werden dabei die Ausschläge der Signale vorrangig durch Signalrauschen verursacht. Dagegen kann z. B. ein Kurzschluss der Grund für Signale gemäß der rechts gezeigten Abbildungen sein.

## Patentansprüche

1. Verfahren (100) zur Detektion eines kritischen Zustands bei zumindest einer Batteriezelle einer Batterie, wobei
eine Überwachungsvorrichtung (10) vorgesehen ist, und
die Überwachungsvorrichtung (10) eine gemessene Spannung (110) an der Batteriezelle erfasst und eine modellierte Spannung (120) aus einem Modell bestimmt,
umfassend die nachfolgenden Schritte,
a) Vergleichen einer gemessenen Veränderung (112) der gemessenen Spannung (110) der Batteriezelle mit einer modellierten Veränderung (122) der modellierten Spannung (120), wobei in Abhängigkeit von diesem Vergleich ein Vergleichssignal (130) der Batteriezelle bestimmt wird,
b) Auswerten des Vergleichssignals (130) der Batteriezelle zur Detektion des kritischen Zustands, **gekennzeichnet durch** den folgenden Schritt,
c) Vergleichen eines durchschnittlichen Vergleichssignals (132), insbesondere gebildet aus weiteren Vergleichssignalen von wenigstens zwei oder mehr oder sämtlichen weiteren Batteriezellen der Batterie, mit dem Vergleichssignal (130) der, insbesondere einzelnen, Batteriezelle, zur Bestimmung eines ersten Auswertungssignals (140).

2. Verfahren (100) nach Anspruch 1,
**dadurch gekennzeichnet,**
**dass** gemäß Schritt a) eine erste Filterung (20), insbesondere eine erste Hochpass-Filterung (20), an der gemessenen Spannung (110) zur Bestimmung der gemessenen Veränderung (112) durchgeführt wird, und vorzugsweise eine zweite Filterung (22), insbesondere eine zweite Hochpass- Filterung (22), an der modellierten Spannung (120) zur Bestimmung der modellierten Veränderung (122) durchgeführt wird, und für den Vergleich gemäß Schritt a) bevorzugt die Differenz zwischen der gemessenen Veränderung (112) und der modellierten Veränderung (122) gebildet wird.

3. Verfahren (100) nach Anspruch 1 oder 2,
**dadurch gekennzeichnet,**
**dass** zur Auswertung des Vergleichssignals (130) gemäß Schritt b) der nachfolgende Schritt durchgeführt wird, insbesondere nach Schritt c):
d) Kompensieren von systematischen Fehlereinflüssen, insbesondere bei dem ersten Auswertungssignal (140), zur Bestimmung eines zweiten Auswertungssignals (150).

4. Verfahren (100) nach Anspruch 3,
**dadurch gekennzeichnet,**
**dass** zur Auswertung des Vergleichssignals (130) gemäß Schritt b) der nachfolgende Schritt durchgeführt wird, insbesondere nach Schritt d):
e) Vergleichen des zweiten Auswertungssignals (150) der Batteriezelle mit einem weiteren zweiten Auswertungssignal (151) von einer weiteren Batteriezelle, insbesondere durch Berechnung der Differenz, um ein Detektionssignal (160) zu bestimmen, insbesondere nur dann, wenn das zweite Auswertungssignal (150) der Batteriezelle einem maximalen Auswertungssignal der Batterie entspricht, wobei insbesondere das weitere zweite Auswertungssignal (151) der weiteren Batteriezelle einem zweithöchsten Auswertungssignal der Batterie entspricht.

5. Verfahren (100) nach einem der Ansprüche 3 oder 4,
**dadurch gekennzeichnet,**
**dass** zur Auswertung des Vergleichssignals (130) gemäß Schritt b) die nachfolgenden Schritte durchgeführt werden, insbesondere nach Schritt e):
f) Bestimmen eines Integrationssignals (170), insbesondere durch Integrieren und/oder Aufsummieren des Detektionssignals (160),
g) Verwerfen des Integrationssignals (170), wenn das zweite Auswertungssignal (150) der Batteriezelle sich von einem maximalen Auswertungssignal der Batterie unterscheidet.

6. Verfahren (100) nach Anspruch 5,
**dadurch gekennzeichnet,**
**dass** der kritische Zustand, insbesondere ein interner Kurzschluss der Batteriezelle, gemäß Schritt b) nur dann positiv detektiert wird, wenn das Integrationssignal (170) einen vordefinierten Schwellenwert überschreitet.

7. Verfahren (100) nach einem der vorhergehenden Ansprüche,
**dadurch gekennzeichnet,**
**dass** für zumindest 50 % oder zumindest 80 % oder zumindest 90 % oder für sämtliche der Batteriezellen der Batterie jeweils die Schritte a) und b), und insbesondere wenigstens einer der Schritte c) bis g), durchgeführt werden, wobei insbesondere das Integrationssignal (170) und/oder das Detektionssignal (160) stets nur für die Batteriezelle mit dem maximalen Auswertungssignal der Batterie ermittelt wird.

8. Überwachungsvorrichtung (10) zur Detektion eines kritischen Zustands bei zumindest einer Batteriezelle einer Batterie, aufweisend:
- zumindest eine Messeinheit (11) zur Erfassung jeweils einer gemessenen Spannung (110) für jede Batteriezelle,
- zumindest eine Auswerteeinheit (12) zur Bestimmung von jeweils einer modellierten Spannung (120) aus einem Modell für jede Batteriezelle,
**dadurch gekennzeichnet,**
**dass** die Überwachungsvorrichtung (10) dazu eingerichtet ist, gemäß einem Verfahren (100) nach einem der Ansprüche 1 bis 7 betrieben zu werden.

## Claims

1. Method (100) for detecting a critical state in at least one battery cell of a battery, wherein
a monitoring apparatus (10) is provided, and
the monitoring apparatus (10) records a measured voltage (110) at the battery cell and determines a modelled voltage (120) from a model,
comprising the following steps of
a) comparing a measured change (112) in the measured voltage (110) of the battery cell with a modelled change (122) in the modelled voltage (120), wherein a comparison signal (130) of the battery cell is determined on the basis of this comparison,
b) evaluating the comparison signal (130) of the battery cell in order to detect the critical state, **characterized by** the following step of
c) comparing an average comparison signal (132), in particular formed from further comparison signals of at least two or more or all further battery cells of the battery, with the comparison signal (130) of the battery cell, in particular the individual battery cell, in order to determine a first evaluation signal (140) .

2. Method (100) according to Claim 1,
**characterized in that**
according to step a), first filtering (20), in particular first high-pass filtering (20), is carried out on the measured voltage (110) in order to determine the measured change (112), and second filtering (22), in particular second high-pass filtering (22), is preferably carried out on the modelled voltage (120) in order to determine the modelled change (122), and the difference between the measured change (112) and the modelled change (122) is preferably formed for the comparison according to step a).

3. Method (100) according to Claim 1 or 2,
**characterized in that**
in order to evaluate the comparison signal (130) according to step b), the following step is carried out, in particular after step c):
d) compensating for systematic error influences, in particular in the first evaluation signal (140), in order to determine a second evaluation signal (150).

4. Method (100) according to Claim 3,
**characterized in that**
in order to evaluate the comparison signal (130) according to step b), the following step is carried out, in particular after step d):
e) comparing the second evaluation signal (150) of the battery cell with a further second evaluation signal (151) of a further battery cell, in particular by calculating the difference, in order to determine a detection signal (160), in particular only when the second evaluation signal (150) of the battery cell corresponds to a maximum evaluation signal of the battery, wherein the further second evaluation signal (151) of the further battery cell corresponds, in particular, to a second-highest evaluation signal of the battery.

5. Method (100) according to either of Claims 3 and 4,
**characterized in that**
in order to evaluate the comparison signal (130) according to step b), the following steps are carried out, in particular after step e):
f) determining an integration signal (170), in particular by integrating and/or adding the detection signal (160),
g) rejecting the integration signal (170) if the second evaluation signal (150) of the battery cell differs from a maximum evaluation signal of the battery.

6. Method (100) according to Claim 5,
**characterized in that**
the critical state, in particular an internal short circuit of the battery cell, is positively detected according to step b) only when the integration signal (170) exceeds a predefined threshold value.

7. Method (100) according to one of the preceding claims,
**characterized in that**
steps a) and b), and in particular at least one of steps c) to g), are respectively carried out for at least 50% or at least 80% or at least 90% or for all of the battery cells of the battery, wherein the integration signal (170) and/or the detection signal (160) is/are always determined, in particular, only for the battery cell with the maximum evaluation signal of the battery.

8. Monitoring apparatus (10) for detecting a critical state in at least one battery cell of a battery, having:
- at least one measuring unit (11) for recording a respective measured voltage (110) for each battery cell,
- at least one evaluation unit (12) for determining a respective modelled voltage (120) from a model for each battery cell,
**characterized in that**
the monitoring apparatus (10) is configured to be operated in accordance with a method (100) according to one of Claims 1 to 7.

## Revendications

1. Procédé (100) de détection d'un état critique dans au moins un élément de batterie d'une batterie, dans lequel
il est prévu un dispositif de surveillance (10), et
le dispositif de surveillance (10) détecte une tension mesurée (110) aux bornes de l'élément de batterie et détermine une tension modélisée (120) à partir d'un modèle,
comprenant les étapes suivantes
a) comparaison d'une variation mesurée (112) de la tension mesurée (110) de la cellule de batterie à une variation modélisée (122) de la tension modélisée (120), un signal de comparaison (130) de la cellule de batterie étant déterminé en fonction de cette comparaison,
b) évaluation du signal de comparaison (130) de la cellule de batterie pour la détection de l'état critique, **caractérisé par** l'étape suivante,
c) comparaison d'un signal de comparaison moyen (132), calculé en particulier à partir d'autres signaux de comparaison d'au moins deux ou plus ou de la totalité des autres cellules de batterie de la batterie, au signal de comparaison (130) de la cellule de batterie, en particulier individuelle, pour déterminer un premier signal d'évaluation (140).

2. Procédé (100) selon la revendication 1, **caractérisé**
**en ce que**, selon l'étape a), un premier filtrage (20), en particulier un premier filtrage passe-haut (20), est effectué sur la tension mesurée (110) pour déterminer la variation mesurée (112), et de préférence un deuxième filtrage (22), en particulier un deuxième filtrage passe-haut (22), est effectué sur la tension modélisée (120) pour déterminer la variation modélisée (122), et **en ce que**, pour la comparaison selon l'étape a), la différence entre la variation mesurée (112) et la variation modélisée (122) est de préférence calculée.

3. Procédé (100) selon la revendication 1 ou 2, **caractérisé**
**en ce que**, pour l'évaluation du signal de comparaison (130) selon l'étape b), l'étape suivante est effectuée, en particulier après l'étape c) :
d) compensation d'influences d'erreurs systématiques, en particulier pour le premier signal d'évaluation (140), pour la détermination d'un deuxième signal d'évaluation (150).

4. Procédé (100) selon la revendication 3,
**caractérisé**
**en ce que**, pour l'évaluation du signal de comparaison (130) selon l'étape b), l'étape suivante est effectuée, en particulier après l'étape d) :
e) comparaison du deuxième signal d'évaluation (150) de la cellule de batterie à un autre deuxième signal d'évaluation (151) provenant d'une autre cellule de batterie, en particulier par calcul de la différence, afin de déterminer un signal de détection (160), en particulier uniquement lorsque le deuxième signal d'évaluation (150) de la cellule de batterie correspond à un signal d'évaluation maximal de la batterie, l'autre deuxième signal d'évaluation (151) de l'autre cellule de batterie correspondant en particulier à un deuxième signal d'évaluation le plus élevé de la batterie.

5. Procédé (100) selon l'une des revendications 3 ou 4,
**caractérisé**
**en ce que**, pour l'évaluation du signal de comparaison (130) selon l'étape b), les étapes suivantes sont effectuées, en particulier après l'étape e) :
f) détermination d'un signal d'intégration (170), en particulier par intégration et/ou sommation du signal de détection (160),
g) rejet du signal d'intégration (170) lorsque le deuxième signal d'évaluation (150) de la cellule de batterie diffère d'un signal d'évaluation maximal de la batterie.

6. Procédé (100) selon la revendication 5,
**caractérisé**
**en ce que** l'état critique, en particulier, un court-circuit interne de la cellule de batterie, n'est détecté positivement selon l'étape b) que si le signal d'intégration (170) dépasse une valeur de seuil prédéfinie.

7. Procédé (100) selon l'une des revendications précédentes,
**caractérisé**
**en ce que** pour au moins 50 % ou au moins 80 % ou au moins 90 % ou pour la totalité des cellules de batterie de la batterie, les étapes a) et b) sont respectivement effectuées, et en particulier au moins l'une des étapes c) à g), le signal d'intégration (170) et/ou le signal de détection (160) n'étant en particulier toujours déterminé que pour la cellule de batterie ayant le signal d'évaluation maximal de la batterie.

8. Dispositif de surveillance (10) pour la détection d'un état critique dans au moins un élément de batterie d'une batterie, comportant :
- au moins une unité de mesure (11) pour détecter respectivement une tension mesurée (110) pour chaque élément de batterie,
- au moins une unité d'évaluation (12) pour déterminer respectivement une tension modélisée (120) à partir d'un modèle pour chaque cellule de batterie,
**caractérisé**
**en ce que** le dispositif de surveillance (10) est conçu pour être utilisé conformément à un procédé (100) selon l'une des revendications 1 à 7.
